# EUROPEAN PATENT APPLICATION

(11) **EP 1 564 795 A2**
(43) Date of publication of application: **17.08.2005**
(21) Application number: 05002942.0
(22) Date of filing: 11.02.2005
(51) Int. Cl.: H01L 21/205

(54) **Method of growing crystal of compound semiconductor and method of manufacturing compound semiconductor device**

(30) Priority: 16.02.2004 JP 2004038520
(71) Applicant: SEIKO EPSON CORPORATION, Shinjuku-ku, Tokyo 163-0811 (JP)
(72) Inventor: Nishida, Tetsuo, Suwa-shi, Nagano-ken 392-8502 (JP)
(74) Representative: HOFFMANN - EITLE

(57) **Abstract**

A method of growing crystals of compound semiconductor having good quality is provided.
The method of growing crystals of compound semiconductor according to the present invention is related to a method of growing crystals of Group III-V compound semiconductor that contains nitrogen among Group V elements using nitride materials by means of a metal organic chemical vapor deposition method, the method comprises changing an amount of the nitride materials to be supplied to the reaction chamber during a predetermined period after supplying the nitride materials to a reaction chamber.

## Description

### [Technical Field]

The present invention relates to a method of growing crystals of compound semiconductor and a method of manufacturing a compound semiconductor device.

### [Background Art]

As the internet is widely spread, fiber cables have been equipped to many homes, known as FTTH (Fiber To The Home). Contrary to trunk optical communications (e.g., optical communications between base stations), low cost and low power consumption are important factors required in this branch optical communications. Therefore, devices used in such trunk optical communications could not be directly adapted to the branch optical communications like those in homes.

In a trunk line, a semiconductor laser containing InGaAsP is generally used as a semiconductor laser having an emission wavelength of 1.3 µm. However, recently, in place of the above semiconductor laser, as light-emitting elements which have advantages in both price and power consumption, a semiconductor having a material containing nitrogen, such as GaInNAs, have been studied. The semiconductor laser has the emission wavelength of 1.3 µm. For example, the semiconductor laser having GaInNAs and 1.3 µm wavelength range is inexpensive and has low power consumption. Especially, the semiconductor laser having GaInNAs and 1.3 µm wavelength range does not require a temperature control device such as a peltier device that is used in the conventional light-emitting elements. Thus, GaInNAs has been found to be the most effective material for the semiconductor laser having 1.3 µm wavelength range. With respect to semiconductor lasers having the other wavelength ranges, a compound semiconductor containing nitrogen has received attention, such as a semiconductor layer having GaN and a short wavelength range.

Therefore, methods of growing crystals of compound semiconductor have been developed. For example, Japanese Unexamined Patent Application Publication No. 11-238685 discloses a method of satisfactorily growing GaInNAs crystals.

### [Disclosure of the Invention]

### [Problems to be Solved by the Invention]

An object of the present invention is to provide a method of growing crystals of compound semiconductor having a good quality.

Another object of the present invention is to provide a method of manufacturing a device adapting a method of growing crystals of compound semiconductor.

### [Means for Solving the Problems]

A method of growing crystals of the compound semiconductor of the present invention is a method of growing crystals of Group III-V compound semiconductor that contains nitrogen among Group V elements using nitride materials by means of a metal organic chemical vapor deposition method. The method comprises changing an amount of the nitride materials supplied to the reaction chamber during a predetermined period after supplying the nitride materials to a reaction chamber.

Generally, in the case of growing crystals of Group III-V compound semiconductor that contains nitrogen among Group V elements using the nitride materials, since the nitrogen is difficult to be accepted in a crystalline structure compared to another elements, sufficiently larger amount of nitride materials than III group materials should be supplied to the reaction chamber.

According to the method of growing crystals of compound semiconductor of the present invention, even when a large amount of nitride materials is supplied into the reaction chamber, by changing the amount of the nitride materials supplied to the reaction chamber during a predetermined period after supplying the nitride materials to the reaction chamber, it is possible to prevent a bad influence on a crystal quality of an epitaxial layer caused by a disturbance of an airflow in the reaction chamber. In addition, it is possible to obtain a high-quality compound semiconductor in which elements are uniformly dispersed in a plane.

According to the method of growing crystals of compound semiconductor of the present invention, an amount of supplied nitride materials may be continuously changed. In this case, the amount of supplied nitride material may be increased, and the amount of supplied the nitride material may be increased linearly.

According to the method of growing crystals of compound semiconductor of the present invention, an increasing ratio of the supplied amount is determined based on a predetermined composition ratio of nitrogen of the compound semiconductor.

According to the method of growing crystals of compound semiconductor of the present invention, the predetermined period is a period of time that it takes to generate stratified airflow in the reaction chamber. In this case, a disturbance of the airflow in the reaction chamber is stabilized to obtain a high-quality crystal.

According to the method of growing crystals of compound semiconductor of the present invention, the predetermined period is a period of time that it takes to stabilize the pressure variation in the reaction chamber. Also in this case, a disturbance of the airflow in the reaction chamber is stabilized to obtain a high-quality crystal.

According to the method of growing crystals of compound semiconductor of the present invention, the period may be set to a period of time that it takes to make a composition ratio of the nitrogen in a crystal be constant.

According to the method of growing crystals of compound semiconductor of the present invention, the supplied amount may be constant after the predetermined period. In this case, the crystal may be grown in a relatively stable state without disturbance of airflow such as a whirlpool or a turbulent flow, such that a high-quality crystal can be obtained.

The method of growing crystals the present invention can be adapted to grow crystals of Group III-V compound semiconductor containing at least gallium and nitrogen as component materials. These Group III-V compound semiconductors include GaN, InGaN, AlGaN, GaInNAs, etc.

In addition, the method of growing crystals according to the present invention can be adapted to a method of manufacturing a compound semiconductor device.

### [Brief Description of the Drawings]

[Fig. 1] Fig. 1 is a drawing illustrating a MOCVD device.

[Fig. 2] Fig. 2 is a drawing illustrating a control device of controlling an amount of materials in the MOCVD device.

[Fig. 3] Fig. 3 is a cross-sectional view illustrating a process of growing crystals of a compound semiconductor.

[Fig. 4] Fig. 4 is a graph illustrating a relationship between a nitrogen concentration and an amount of supplied nitride materials in accordance with the prior art.

[Fig. 5] Fig. 5 is a graph illustrating a relationship between a nitrogen concentration and an amount of supplied nitride materials in accordance with a first exemplary embodiment of the present invention.

[Fig. 6] Fig. 6 is a cross-sectional view illustrating a process of growing a quantum well structure.

[Fig. 7] Fig. 7 is a drawing illustrating profiles of As, Ga, and N atoms in a multi quantum well structure.

[Fig. 8] Fig. 8 is a cross-sectional view illustrating a process of manufacturing a stripe laser.

[Fig. 9] Fig. 9 is a cross-sectional view illustrating a process of manufacturing a surface emitting laser.

[Fig. 10] Fig. 10 is a cross-sectional view illustrating a process of manufacturing a surface emitting laser.

### [Reference Numerals]

10: REACTION CHAMBER
20: FIRST MATERIAL CHAMBER
22: SECOND MATERIAL CHAMBER
24: THIRD MATERIAL CHAMBER
26: FOURTH MATERIAL CHAMBER
28: FIFTH MATERIAL CHAMBER
31, 37: MATERIAL SUPPLY LINE
32: FIRST DISCHARGE LINE
33: SUPPLEMENT PREPARATION LINE
34: DUMMY LINE
35, 36: CONNECTION SWITCHING DEVICE
38: PRESSURE GAUGE
40: HEATER
50: SUBSTRATE
100: MOCVD DEVICE

### [Best Mode for Carrying Out the Invention]

Hereinafter, preferred embodiments of the present invention will be explained with reference to drawings.

### 1. First Embodiment

In a first embodiment, an example of growing a crystal of GaInNAs selected as an example of Group III-V compound semiconductor that contains nitrogen as a Group V element will be described.

### 1-1. Manufacturing Device

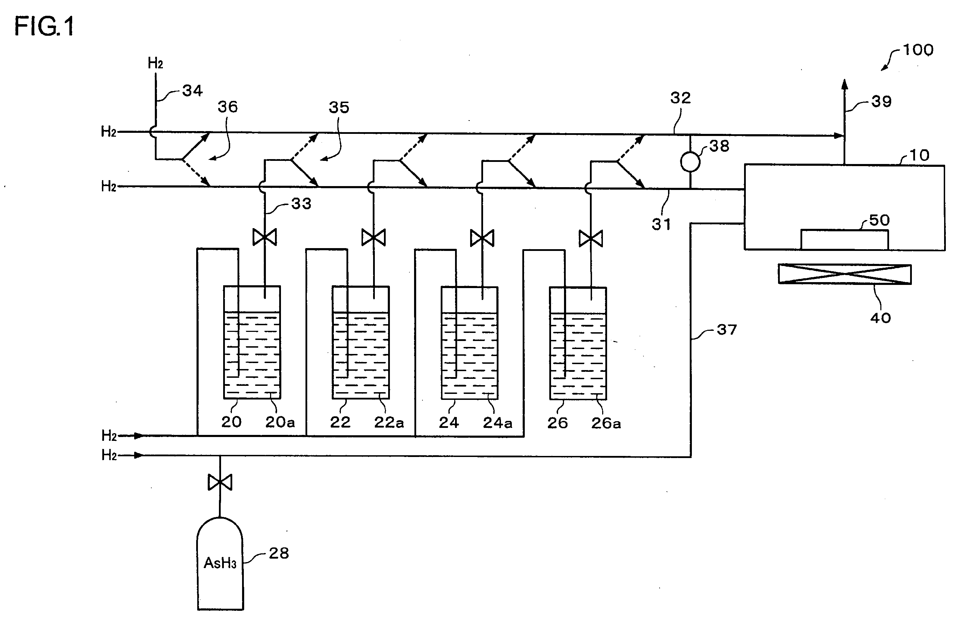

Hereinafter, an MOCVD device (Metal Organic Chemical Vapor Deposition) will be explained, which is used in a method of growing crystals of GaInNAs according to the embodiment of the present invention. Fig. 1 is a schematic view illustrating a MOCVD device.

The MOCVD device 100 includes a reaction chamber 10 and a first through fourth material chambers 20, 22, 24, 26. A heater 40 for controlling a temperature of a substrate 50 in the reaction chamber 10 is provided near the reaction chamber 10. Each of the first through fourth material chambers 20, 22, 24, 26 and the reaction chamber 10 are connected to each other by a material supply line 31. A hydrogen (H₂) gas as a carrier gas is supplied to the material supply line 31.

The MOCVD device 100 includes a first discharge line 32 and a second discharge line 39. The first discharge line 32 is mainly used in controlling an amount of materials supplied into the reaction chamber 10. The second discharge line 39 is mainly used for removing surplus materials or impurities from the reaction chamber 10.

In addition to, the MOCVD device 100 includes a dummy line 34 for controlling an amount of materials supplied to the material supply line 31. The dummy line 34 is connected to the material supply line 31 or the first discharge line 32 by a connection switching device 36 to supply the hydrogen (H₂) gas as a carrier gas.

In the MOCVD device 100, a pressure gauge 38 is provided between the material supply line 31 and the first discharge line 32. The pressure gauge 38 monitors a pressure difference of the material supply line 31 and the first discharge line 32 to control the amount of materials supplied to the reaction chamber 10.

Gallium materials 20a are filled in the first material chamber 20. The gallium materials 20a may include trimethyl gallium (TMGa) and triethyl gallium (TEGa), for example.

Indium materials 22a are filled in the second material chamber 22. The indium materials 22a include trimethyl indium (TMIn), tryethyl indium (TEIn), etc.

Nitride materials 24a are filled in the third material chamber 24. The nitride materials 24a include dimethyl hydrazine (DMHy) and mono-methyl hydrazine (MMHy), etc.

Arsenic materials 26a are filled in the fourth material chamber 26. The arsenic materials 26a include Tertiary Butyl Arsine (TBAs).

The materials are supplied through a supplement preparation line 33 from the first through fourth material chambers 20, 22, 24, 26. The supplement preparation line 33 is provided so as to be connected to the material supply line 31 or the first discharge line by the connection switching device 35.

In addition, if necessary, a fifth material chamber 28 filled with an arsine (AsH₃) gas as an arsenic material may be provided so as to supply arsine to the reaction chamber 10 through a material supply line 37.

In this case, an amount of material gas flowing into the reaction chamber 10 from the material chambers 20, 22, 24, 26 is controlled as follows.

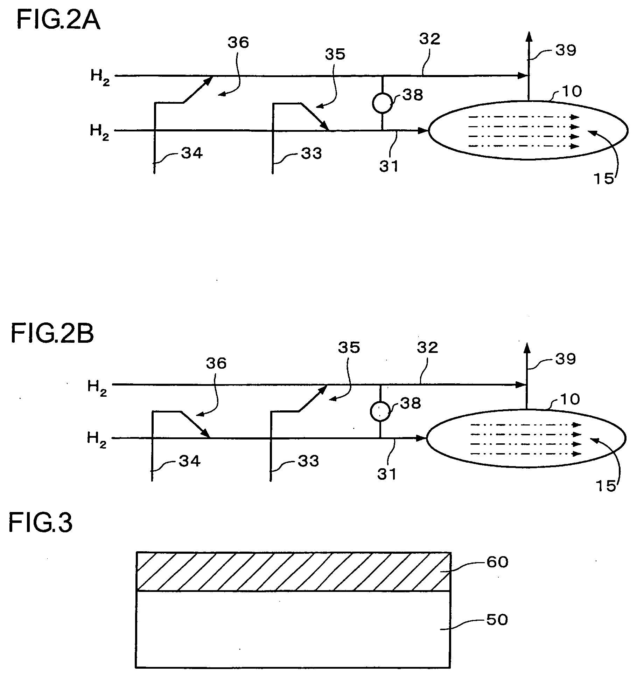

Fig. 2(A) illustrates a connection relation of each line in a state that the material gases are supplied to the material chamber 10. The hydrogen gas (H₂) is supplied through the dummy line 34, as much as the material gas supplied through the supplement preparation line 33. In this case, the connection switching device 35 connects the supplement preparation line 33 to the material supply line 31. The connection switching device 36 connects the dummy line 34 to the first discharge line 32. Thus, a flow rate of the material supply line 31 becomes nearly the same as that of the first discharge line 32, such that a pressure difference does not occur between lines. Accordingly, stratified airflow (laminar flow) 15 is generated in the reaction chamber 10.

Fig. 2(B) illustrates a connection relationship of each line in a state that supplement of material gases into the reaction chamber 10 is stopped. The hydrogen gas (H₂) is supplied through the dummy line 34, in the same amount as the material gas supplied through the supplement preparation line 33. In this case, the connection switching device 35 connects the supplement preparation line 33 to the first discharge line 32. The connection switching device 36 connects the dummy line 34 to the material supply line 31. Thus, a flow rate of the material supply line 31 becomes nearly the same as that of the first discharge line 32, such that a pressure difference does not occur between lines. Accordingly, the disturbance of airflow does not occur in the reaction chamber 10, and the stratified airflow (laminar flow) is maintained in the reaction chamber 10 in this state.

The MOCVD device 100 controls the flow rate (the amount) of the material gases or the pressure of the reaction chamber 10 so as to form the stratified airflow dispersed a little in the reaction chamber 10. In addition, in order to achieve a high-quality crystal layer when growing crystals in the reaction chamber 10, the stratified airflow (laminar flow) 15 may be generated around a material where the crystal layer is formed such as a substrate provided in the reaction chamber 10.

### 1-2. Method of forming a GaInNAs layer

Each of the materials 20a, 22a, 24a, 26a filled in the first through fourth material chambers 20, 22, 24, 26 is bubbled by the hydrogen (H₂) as a carrier gas to be introduced into the reaction chamber 10. When crystals of GaInNAs are grown, the arsenic gas filled up in the fifth material chamber 28 may be introduced into the reaction chamber 10 together with the hydrogen gas as the carrier gas. Each of the materials 20a, 22a, 24a, 26a is thermally decomposed to be stacked on the substrate 50 (e.g., a GaAs substrate) in the reaction chamber 10. Thus, a GaInNAs layer 60 is formed as shown in Fig. 3. In addition to, a composition ratio of the GaInNAs is generally referred to as Ga₁₋ₓInₓN_{y}As_{1-y}.

When growing GaInNAs crystals, an amount ratio of Group V (N, As) materials to III group (Ga, In) materials may be set to several times through hundred times. An amount ratio of nitride materials (DMHy or MMHy) to arsenic materials (AsH3 or TBAs) may be set to ten times through hundred times. In the growth of GaInNAs crystals, a temperature of the substrate may be set to, for example, 400°C to 700°C. In addition, a pressure of the reaction chamber 10 may be fixed to, for example, about 100 mbar. The amount of each material gas flowing into the reaction chamber 10 is controlled as shown in Figs. 2(A) and 2(B).

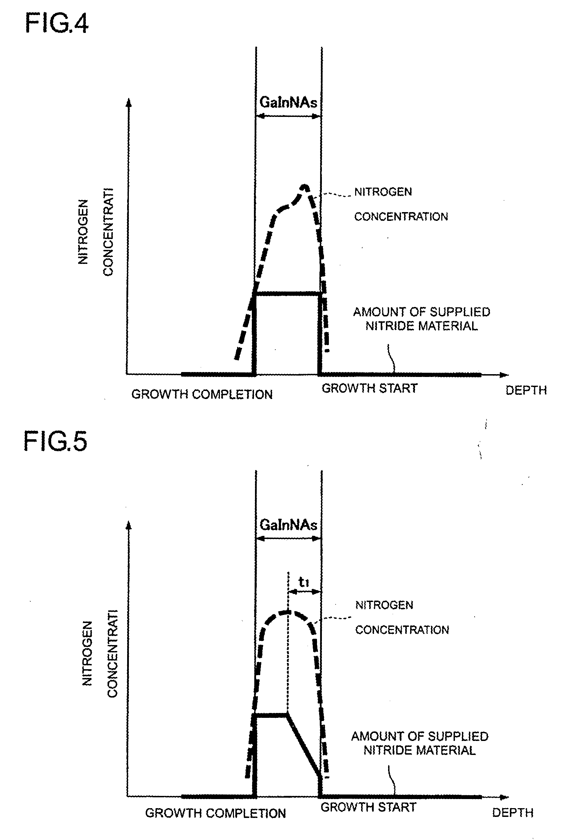

Fig. 4 is a conceptional graph illustrating a relationship between a nitrogen concentration and an amount of supplied nitride materials in the GaInNAs crystals grown by means of a conventional method of growing crystals. In the conventional method of growing GaInNAs crystals, the amount of supplied nitride materials is constant from a start to an end of the crystalline growth. Therefore, a large amount of nitride materials are supplied to the reaction chamber 10 at the start, such that a pressure is applied to the reaction chamber 10. Thus, elements in the crystals are not uniformly arranged due to the pressure. According to the conventional method of growing crystals, the nitrogen concentration is not uniform, such that it is hard to obtain a good qualified GaInNAs layer.

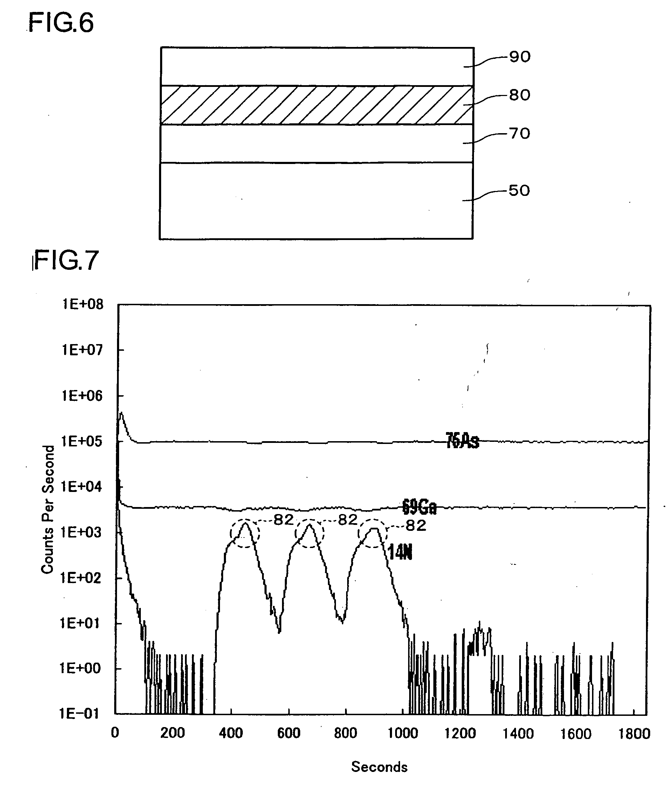

Fig. 5 is a conceptional graph illustrating a relationship between a nitrogen concentration and an amount of supplied nitride materials in the GaInNAs crystals grown by means of a method of growing crystals according to the exemplary embodiment of the present invention. In the method of growing the GaInNAs crystal according to this embodiment of the present invention, the amount of the nitride materials supplied to the reaction chamber 10 is increased linearly from a start point to an end of a period t1. After the period t1, the amount of the supplied nitride materials is fixed to be constant. In contrast to the conventional method, an initial amount of the supplied nitride materials is small, such that the pressure applied to the reaction chamber 10 can be stabilized. In addition, the amount of the supplied nitride materials is linearly increased to prevent a drastic variation of the pressure from the start point to the completion of the crystalline growth. The nitrogen concentration in the GaInNAs layer can be made uniform compared to the conventional method by increasing the amount of the supplied nitride material linearly as shown in Fig. 5. Therefore, according to the method of growing crystals of the present invention, a good qualified GaInNAs layer may be obtained.

In this case, the period t1 is a time until the pressure variation of the reaction chamber 10 becomes stable or until stratified airflow (laminar flow) occurs in the reaction chamber 10.

The increasing ratio of the amount of the supplied nitride materials is determined based on a composition ratio of nitrogen in the GaInAs semiconductor. The initial value of an amount of the supplied nitride materials and the increased value are also determined based on the composition ratio of the GaInNAs semiconductor. For instance, in order to obtain a GaInNAs layer having a desirable composition ratio, the increasing ratio is raised as high as the composition ratio of the nitrogen is.

Alternatively, although the amount of the supplied nitride material is linearly increased in the method of growing the crystals according to this embodiment of the present invention, the amount of the supplied nitride materials may be increased nonlinearly.

### 2. Second exemplary embodiment

Hereinafter, a method of forming a quantum well structure of GaAs/GaInNAs/GaAs layer will be explained as a method of growing crystals of compound semiconductor according to the second embodiment of the present invention.

In this embodiment of the present invention, the MOCVD device 100 in Fig. 1 may be used in growing crystals in each layer, similar to the first embodiment of the present invention.

Specifically referring to Fig. 6, a GaAs barrier layer 70, a GaInNAs potential well layer 80, and a GaAs barrier layer 90 are subsequently stacked on a substrate (e.g., a GaAs substrate) 50 to form a quantum well structure.

Fig. 7 illustrates a profile of As, Ga, and N atoms in a direction of a thickness of a sample layer in a multiple quantum well structure comprising GaAs/GaInNAs/GaAs layers, which are formed by the conventional method of growing the crystals by means of a secondary ion mass spectroscopy (SIMS) method with injecting a primary ion of cesium.

The sample layer is formed by a crystalline growth of GaInNAs well layer 80 with supplements of a specific amount of nitride materials (e.g., DMHy or MMHy) from a start to an end of the crystalline growth.

A peak profile of the nitrogen atom includes a region 82 in which the nitrogen concentration is nonuniform as the peak profile of the nitrogen concentration shown in Fig. 4. That is, the nitrogen concentration is not uniform in the region 82 in Fig. 7, such that it is difficult to achieve crystals of GaAs/GaInNAs/GaAs quantum well having good quality, in the conventional method of growing the crystals.

In the second embodiment of the present invention, the amount of the supplied nitride materials to the reaction chamber 10 is increased linearly from a start of the supplied nitride materials to an end of a period t1. After the period t1, the amount of the supplied nitride materials is fixed uniformly as in the first embodiment of the present invention. Contrary to the conventional method, since an initial amount of the supplied nitride materials is small, an impact and a pressure applied to the reaction chamber 10 immediately after supplying the material can be stabilized. In addition, the amount of the supplied nitride materials is linearly increased to prevent a drastic variation of the pressure from the start point to the end of the crystalline growth of the GaInNAs well layer 80. The nitrogen concentration in the GaInNAs well layer 80 can be made more uniform than that using the conventional method by increasing the amount of providing the nitride material linearly. Therefore, according to the method of growing crystals of the present invention, a good qualified GaInNAs layer can be achieved.

### 3. Third Embodiment

Hereinafter, a method of manufacturing a light-emitting element according to a third embodiment of the present invention will be explained. In addition to, a light-emitting element will be explained taking a stripe laser and a surface emitting laser as an example.

### 3-1. Method of manufacturing stripe laser

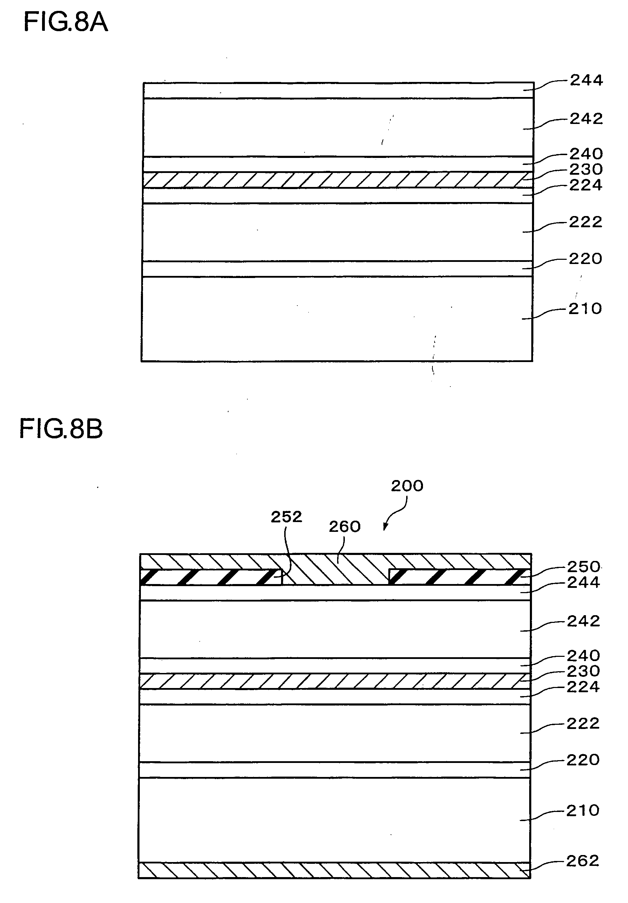

Hereinafter, a method of manufacturing a stripe laser will be described in accordance with the embodiment of the present invention. Fig. 8 is a cross-sectional view schematically illustrating a process of manufacturing a stripe laser.

First, referring to Fig. 8(A), an n-type buffer layer 220, an n-type cladding layer 222, and an barrier layer 224 are sequentially stacked on an n-type GaAs substrate 210 by means of a metal organic chemical vapor deposition (MOCVD) method, epitaxially growing with modulating a composition.

The n-type buffer layer 220 comprises n-type GaAs doped with, for example, silicon. The n-type cladding layer 222 comprises n-type Al_{0.4}Ga_{0.6} doped with, for example, silicon. A thickness of n-type cladding layer 222 may be, for example, 1500nm. The barrier layer 224 comprises, for example, GaAs. A thickness of the barrier layer 224 may be, for example, 100 nm.

Each of the n-type buffer layer 220, the n-type cladding layer 222, and the barrier layer 224 may be formed by thermally decomposing materials of atoms composing the layer, which is introduced in a reaction chamber. In this case, a temperature of a substrate is, for example, 500 to 800°C. A pressure of the reaction chamber may be 100 mbar (10⁴ Pa). The aluminum material is, for example, trimethyl aluminum (TMAl) or triethyl aluminum (TEAl). The silicon material may be, for example, di silane (Si₂H₆) or mono silane (SiH₄). The gallium material and the arsenic material may be those described above.

Next, a GaInNAs layer 230 is formed as a well layer. A composition ration of the GaInNAs layer 230 may be, for example, Ga_{0.65}In_{0.35}N_{0.01}As_{0.99}. A method of forming the GaInNAs layer 230 on the barrier layer 224 may use the method of growing crystals in a quantum well structure of GaAs/GaInNAs/GaAs in accordance with the second embodiment of the present invention. A thickness of the GaInNAs layer 230 may be, for example, 10 nm.

Next, a barrier layer 240, a p-type cladding layer 242, and a p-type contact layer 244 are sequentially stacked on the GaInNAs layer 230 by means of the Metal Organic Chemical Vapor Deposition Method (MOCVD method), epitaxially growing with modulating composition. In this case, a method of forming the barrier layer 240 on the GaInNAs layer 230 may use a method of growing crystals in a quantum well structure of GaAs/GaInNAs/GaAs in accordance with the second embodiment of the present invention.

The barrier layer 240 is comprised of, for example, GaAs. A thickness of the barrier layer 240 may be, for example, 100 nm. The p-type cladding layer 242 may be comprised of p-type Al_{0.4}Ga_{0.6}As doped with Zn. A thickness of the p-type cladding layer 242 may be, for example, 1500 nm. The p-type contact layer 244 is formed of, for example, GaAs doped with Zn. A thickness of the p-type contact layer 244 may be 50 nm.

Each of the barrier layer 240, the p-type cladding layer 242, and the p-type contact layer 244 may be formed by thermally decomposing materials of atoms composing the layer after being introduced in a reaction chamber. In this case, a temperature of a substrate is, for example, 500 to 800°C. A pressure of the reaction chamber may be 100 mbar (10⁴ Pa). The Zn materials as a doped material may include, for example, diethyl zinc (DEZn) and dimethyl zinc (DMZn). The aluminum material, the gallium material, and the arsenic material may be those described above.

Next, as shown in Fig. 8(B), an insulating layer 250 is formed on the p-type contact layer 244 in the manner of a conventional method. The insulating layer 250 includes a stripe-shaped penetrating hole 252. A width of the penetrating hole 252 may be, for example, 5 µm. The insulating layer 250 may be formed of, for example, silicon oxide.

A p electrode 260 comprising a metal layer is formed on the p-type contact layer 244 and the insulating layer 250 by means of a deposition method. The p electrode may be in a structure where, for example, a Cr layer, an AuZn layer, and an Au layer are sequentially stacked.

Next, a back side of the n-type GaAs substrate 210 is polished to, for example, a thickness of 100 µm. Then, an n electrode 262 comprising a metal layer is formed on the back side of the n-type GaAs substrate 210 by means of a deposition method. The n electrode 262 may be adopted in structure of, for example, sequentially stacked Cr, AuGe, Ni, and Au layers. Accordingly, the strip laser 200 is formed.

The stripe laser 200 has effects as follows.

The quantum wells structure of the stripe laser comprising the barrier layer 224, the well layer 230, and the barrier layer 240 is formed by the method of growing crystals in accordance with the second embodiment of the present invention. Thus, a quantum well structure comprising GaAs/GaInNAs/GaAs layers having good qualified crystals. As a result, an excellent stripe laser can be manufactured having good characteristics.

### 3-2. Method of manufacturing surface emitting semiconductor laser

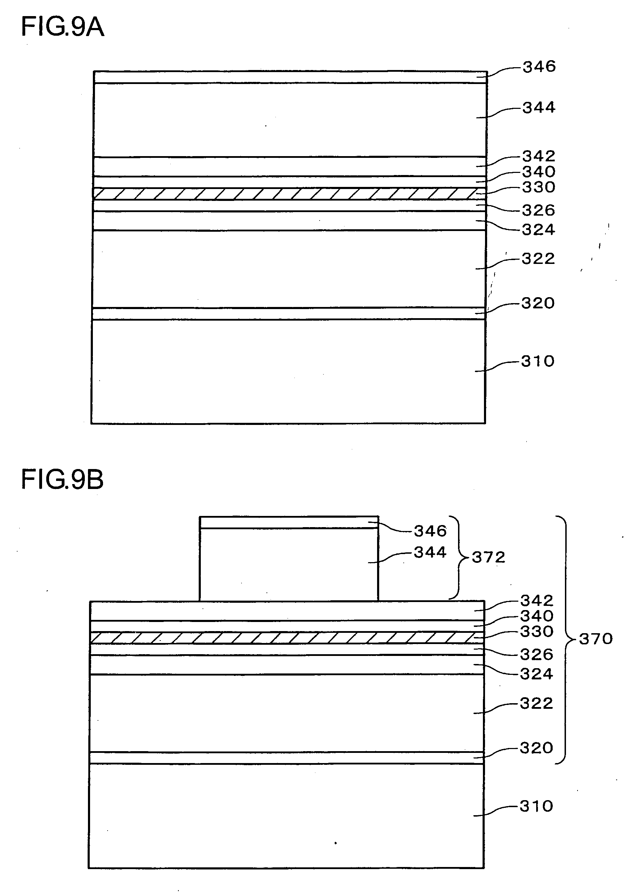

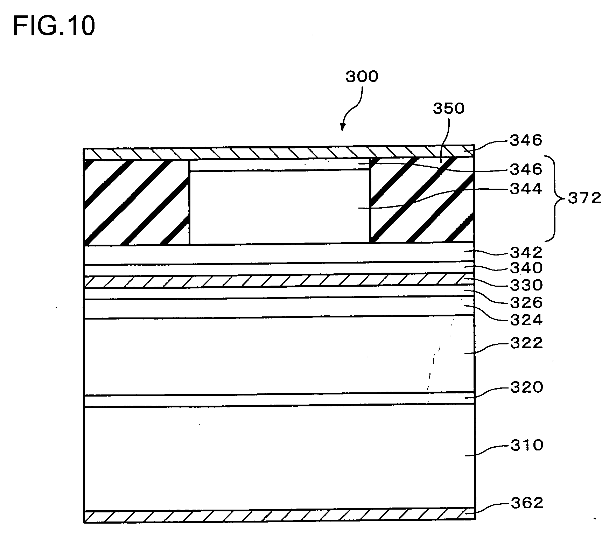

Hereinafter, a method of manufacturing a surface emitting semiconductor laser (referred to as a surface emitting laser) will be explained in accordance with the second embodiment of the present invention. Fig. 9 and Fig. 10 are cross-sectional views schematically illustrating a process of manufacturing the surface emitting laser in accordance with the second embodiment of the present invention.

Referring to Fig. 9(A), a buffer layer 320, an n-type lower DBR mirror 322, an n-type cladding layer 324, and an barrier layer 326 are sequentially stacked on an n-type GaAs substrate 310 by means of a metal organic chemical vapor deposition (MOCVD) method, epitaxially growing with modulating a composition.

The buffer layer 320 may be formed of, for example, GaAs doped with silicon. The n-type lower DBR mirror 322 may be formed of, for example, 35 pairs of distribution reflective multilayered mirrors in which an n-type GaAs layer and an n-type AlAs layer are alternatively stacked. Each thickness of the n-type GaAs layer and the n-type AlAs layer may be a thickness of an optical layer corresponding to a quarter of oscillating wavelength of the surface emitting laser (a 1/4 thickness divided by a refractive index of the layer). The n-type cladding layer may be formed of, for example, Al_{0.3}Ga_{0.7}As doped with silicon. The barrier layer 326 may be formed of, for example, GaAs.

Each of the buffer layer 320, the n-type lower DBR mirror 322, the n-type cladding layer 324 and the barrier layer 326 may be formed thermally decomposing materials of atoms composing the layer, after being introduced in a reaction chamber. In this case, a temperature of a substrate is, for example, 500 to 800°C. A pressure of the reaction chamber may be 100 mbar (10⁴ Pa). As the gallium material and the arsenic material can be used those described above. The aluminum material and the silicon material may be those explained in the method of manufacturing the stripe laser.

Next, a GaInNAs layer 330 is formed as a well layer. A composition ratio of the GaInNAs layer 330 may be Ga_{0.65}In_{0.35}N_{0.01}As_{0.99}. A method of forming the GaInNAs layer 330 on the barrier layer 326 may use the method of growing crystals in a structure of quantum well of GaAs/GaInNAs/GaAs in accordance with the second embodiment of the present invention. A thickness of the GaInNAs layer 330 may be, for example, 10 nm.

A barrier layer 340, a p-type cladding layer 342, a p-type upper DBR mirror 344, and a p-type contact layer 346 are sequentially stacked on the GaInNAs layer 330 by means of a metal organic chemical vapor deposition (MOCVD) method, epitaxially growing with modulating a composition. In this case, a method of forming the barrier layer 340 on the GaInNAs layer 330 may use the method of growing crystals in a structure of quantum well of GaAs/GaInNAs/GaAs in accordance with the second embodiment of the present invention.

The barrier layer 340 may be formed of, for example, GaAs. The p-type cladding layer 342 may be formed of, for example, p-type Al_{0.3}Ga_{0.7}As doped with Zn. The p-type upper DBR mirror 344 may be formed of, for example, 23 pairs of distribution reflective multilayered mirrors in which a p-type GaAs layer and a p-type AlAs layer are alternatively stacked. Each thickness of the p-type GaAs layer and the p-type AlAs layer may be a thickness of an optical layer corresponding to a quarter of oscillating wavelength of the surface emitting laser. The p-type contact layer 346 may be formed of, for example, p-type GaAs doped with Zn. A thickness of the p-type contact layer 346 may be, for example, 50 nm.

Each of the barrier layer 340, the p-type cladding layer 342, the p-type upper DBR mirror 344, and the p-type contact layer 346 may be formed by thermally decomposing materials of atoms composing the layer, after being introduced in a reaction chamber. In this case, a temperature of a substrate is, for example, 500 to 800°C. A pressure of the reaction chamber may be 100 mbar (10⁴ Pa). The gallium material and the arsenic material may be those described above. The aluminum material and the zinc material may be those explained in the method of manufacturing the stripe laser.

Referring to Fig. 9(B), the p-type contact layer 346 and the p-type DBR mirror 344 are patterned using a conventional photolithography technique and an etching method, thereby forming a pillar portion 372. Therefore, a resonator 370 of the surface emitting laser is formed. Then, referring to Fig. 10, an insulating layer (e.g., a polyimide layer) 350 is formed around the pillar portion 372. Specifically, polyimide is coated and hardened and then planarized to form the insulating layer 350.

A first electrode 360 is formed on the pillar portion 372 and the insulating layer 350 by using a conventional method. The first electrode may be formed of a metal layer like the p electrode 260 of the stripe laser. A second electrode 362 is formed on a back side of the n-type GaAs substrate 310 in the manner of the prior art. The second electrode 362 may be formed of a metal layer like the n electrode 262 of the stripe laser. Accordingly, the surface emitting laser 300 can be formed.

The above surface emitting laser 300 has effects as follows.

The barrier layer 326, the GaInNAs layer 330, and the barrier layer 340 of the surface emitting laser are formed in the manner of growing crystals in a structure of quantum well of GaAs/GaInNAs/GaAs in accordance with the second embodiment of the present invention. Thus, the quantum well structure can be formed to have good qualified layer. As a result, a surface emitting laser having good characteristics can be fabricated.

In addition, a laser of a long wavelength bandwidth (for example, 1310 nm) can be embodied using the surface emitting laser 300 comprising the GaInNAs layer 330.

Although the invention has been described as preferred embodiments, it is to be understood that the invention is not limited to the specific embodiment, but various modifications can be made within the scope of the invention.

For instance, a case of a crystalline growth of a GaInNAs layer is taken as an example in the first embodiment. However, the present invention is not limited to this but adapted to a crystalline growth of Group III-V compound semiconductor containing at least gallium and nitrogen as compound elements. The Group III-V compound semiconductor includes, for example, GaN, InGaN, AlGaN, GaInNAs, etc.

A case of a crystalline growth of a GaAs/GaInNAs/GaAs quantum well structure is taken as an example in the second embodiment. However, the present invention is not limited to this but adapted to a crystalline growth of a quantum well structure of Group III-V compound semiconductor containing at least gallium and nitrogen as compound elements in the well layer. The Group III-V compound semiconductor may include the materials described above.

A case of manufacturing a stripe laser and a surface emitting laser as a light-emitting element are taken as an example in the third embodiment. However, the present invention is not limited to these but adapted to methods of manufacturing a light-emitting diode including a Group III-V component semiconductor containing at least gallium and nitrogen as compound elements in the active layer. The Group III-V compound semiconductor may include the materials described above.

In addition, the method of growing crystals of compound semiconductor according to the present invention is not limited to a light-emitting element but the other compound semiconductor device such as a light-receiving element, a solar battery, electronic device including a field effect transistor, etc. In the field effect transistor, the method of the present invention is adapted to form a contact layer or an active layer.

## Claims

1. A method of growing crystals of Group III-V compound semiconductor that contains nitrogen among Group V elements using nitride materials by means of a metal organic chemical vapor deposition method, comprising:
changing an amount of the nitride materials to be supplied to the reaction chamber during a predetermined period after supplying the nitride materials to a reaction chamber.

2. The method of growing crystals of compound semiconductor according to Claim 1, wherein the supplied amount is continuously changed.

3. The method of growing crystals of compound semiconductor according to Claim 1 or 2, wherein the supplied amount is increased.

4. The method growing crystals of compound semiconductor according to Claim 3, wherein the supplied amount is increased linearly.

5. The method of growing crystals of compound semiconductor according to Claim 3 or 4, wherein an increasing ratio of the supplied amount is determined based on a predetermined composition ratio of nitrogen in the compound semiconductor.

6. The method of growing crystals of compound semiconductor according to any one of Claims 1 to 5, wherein the predetermined period is a period of time that it takes to generate stratified airflow in the reaction chamber.

7. The method of growing crystals of compound semiconductor according to any one of Claims 1 to 5, wherein the predetermined period is a period of time that it takes to stabilize the pressure variation in the reaction chamber.

8. The method of growing crystals of compound semiconductor according to any one of Claims 1 to 7, wherein the supplied amount becomes constant after the predetermined period.

9. The method of growing crystals of compound semiconductor according to any one of Claims 1 to 8, wherein the Group III-V compound semiconductor contains at least gallium and nitrogen as component elements.

10. A method of manufacturing a compound semiconductor device, comprising a method of growing crystals of compound semiconductor according to any one of Claims 1 to 9.
